# EUROPÄISCHE PATENTSCHRIFT

(11) **EP 1 110 313 B1**
(45) Veröffentlichungstag und Bekanntmachung des Hinweises auf die Patenterteilung: **11.02.2004**
(21) Anmeldenummer: 99952303.8
(22) Anmeldetag: 04.08.1999
(51) Int. Cl.: H03H 1/02

(54) **LÖTFREIES, KOAXIALES DURCHFÜHRUNGS-BAUELEMENT**
SOLDERLESS, COAXIAL FEEDTHROUGH COMPONENT
ELEMENT TRAVERSANT COAXIAL ET EXEMPT DE SOUDURES

(30) Priorität: 07.08.1998 DE 19835843
(43) Veröffentlichungstag der Anmeldung: 27.06.2001
(73) Patentinhaber: EPCOS AG, 81669 München (DE)
(72) Erfinder: SCHMITTMANN, Helmut, D-89537 Giengen (DE); STELZL, Gerhard, D-89518 Heidenheim (DE)
(74) Vertreter: Epping, Hermann, Fischer
(86) Internationale Anmeldenummer: PCT/DE1999/002446
(87) Internationale Veröffentlichungsnummer: WO 2000/008754

(56) Entgegenhaltungen:
- EP-A- 0 572 825
- US-A- 4 229 714
- US-A- 4 424 551

## Beschreibung

Die vorliegende Erfindung betrifft ein lötfreies, koaxiales Durchführungs-Bauelement mit wenigstens zwei Elektroden, die in ein Gehäuse des Bauelements eingeführt sind, in welchem mindestens ein Druckelement mit einer Kontaktfläche des Bauelements verspannt ist.

Bisher werden bei koaxialen Durchführungs-Bauelementen, wie beispielsweise Durchführungskondensatoren oder Durchführungsfiltern, Weichlötverbindungen oder angelötete Kontaktelemente verwendet, um äußere Elektroden des Bauelements beispielsweise im Falle eines Durchführungskondensators mit dessen Wickel elektrisch zu verbinden. Derartige Weichlötverbindungen oder angelötete Kontaktelemente sorgen zwar ohne weiteres für eine gute elektrische Verbindung zwischen äußeren Elektroden und Wickel. Sie haben aber den Nachteil, daß bei dem Lötvorgang beträchtliche Wärme entsteht, die sich auf temperaturempfindliche Kunststoff-Kondensatorwickel schädlich auswirkt. Auch sind die Forderungen einer hochfrequenzdichten Kontaktierung der Bauteile oft nur schwierig mit Weichlötverbindungen oder angelöteten Kontaktelementen zu realisieren, die eine gewisse Zugänglichkeit für Werkzeuge benötigen.

Das Dokument US-A-4 229 714 zeigt ein lötfreies, koaxiales Durchführungs-Bauelement mit zwei Elektroden, die in ein Gehäuse des Bauelementes eingeführt sind, in welchem ein Druckelement mit einer Kontaktfläche des Bauelements verspannt ist, wobei zwischen dem Druckelement und der Kontaktfläche eine Unterlegscheibe verspannt ist.

Es ist daher Aufgabe der vorliegenden Erfindung, ein weiteres lötfreies, koaxiales Durchführungs-Bauelement zu schaffen, bei dem auf Weichlötverbindungen oder angelötete Kontaktelemente verzichtet werden kann, und das dennoch eine zuverlässige und hochfrequenzdichte Kontaktierung von temperaturempfindlichen Bauteilen erlaubt.

Diese Aufgabe wird bei einem lötfreien, koaxialen Durchführungs-Bauelement der eingangs genannten Art erfindungsgemäß dadurch gelöst, daß zwischen dem Druckelement und der Kontaktfläche ein Metallgestrick-Kontakt-Element (im folgenden auch Mesh-Gewebe genannt) eingelegt ist.

Für dieses Metallgestrick-Kontakt-Element wird in vorteilhafter Weise ein verzinnter oder vernickelter Kupferdraht oder ein anderer elektrisch gut leitender Draht verwendet.

Das erfindungsgemäße lötfreie, koaxiale Durchführungs-Bauelement zeichnet sich also dadurch aus, daß ein Metallgestrick-Kontakt-Element mit einer Kontaktfläche von Bauteilen, beispielsweise einem Kondensatorwickel, mittels eines Druckelementes mechanisch verspannt ist, so daß durch dieses Metallgestrick-Kontakt-Element ein zuverlässiger elektrischer Kontakt zwischen beispielsweise dem Kondensatorwickel und einer Elektrode hergestellt wird.

Bei dem Durchführungs-Bauelement kann es sich in bevorzugter Weise um einen koaxialen Durchführungskondensator oder aber auch um einen koaxialen Durchführungsfilter handeln.

Nachfolgend wird die Erfindung anhand der Zeichnungen näher erläutert. Es zeigen:
- Fig. 1: ein Schnittbild durch einen koaxialen Durchführungskondensator nach einem ersten Ausführungsbeispiel der Erfindung,
- Fig. 2a, b: ein Schnittbild durch einen koaxialen Durchführungsfilter nach einem zweiten Ausführungsbeispiel der vorliegenden Erfindung in zwei verschiedenen Varianten,
- Fig. 3: eine Schnittdarstellung eines Durchführungsfilters mit einem Sockelgehäuse nach einem weiteren Ausführungsbeispiel der Erfindung,
- Fig. 4: eine Schnittdarstellung eines Durchführungsfilters mit einem Rohrgehäuse nach einem weiteren Ausführungsbeispiel der Erfindung,
- Fig. 5: eine Schnittdarstellung eines Durchführungsfilters mit einem beidseitig verschraubten Flanschgehäuse nach einem weiteren Ausführungsbeispiel der Erfindung, und
- Fig. 6: eine Schnittdarstellung eines Durchführungsfilters mit einem einseitig verschraubten Rohrgehäuse nach einem weiteren Ausführungsbeispiel der Erfindung.

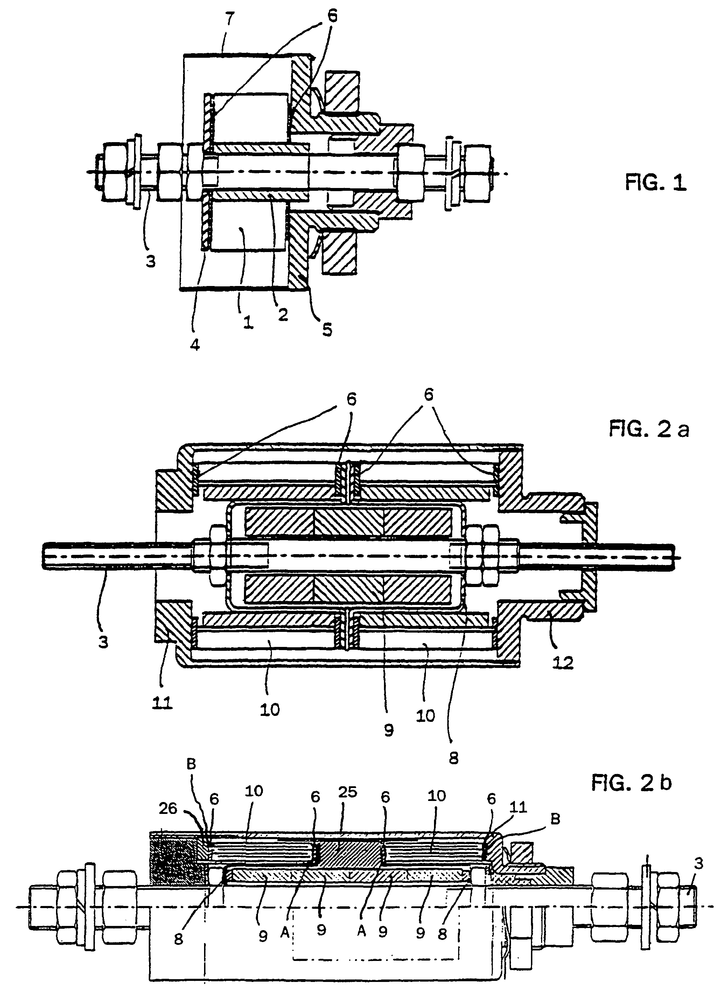

Fig. 1 zeigt einen koaxialen Durchführungskondensator, bei dem ein Kunststoff-Kondensatorwickel 1 über eine Isolierhülse bzw. ein Kernrohr 2 auf einem Gewindebolzen 3 als Durchführungselement vorgesehen ist. Zwischen dem Kunststoff-Kondensatorwickel 1 und eine Kontaktscheibe 4 einerseits und zwischen dem Kunststoff-Kondensatorwickel 1 und einem Gehäuseboden 5 andererseits ist jeweils ein Meshgewebe 6 aus beispielsweise Kupfer angeordnet. Diese Meshgewebe 6 sind zwischen dem Kunststoff-Kondensatorwickel 1 und der Kontaktscheibe 4 bzw. zwischen dem Kunststoff-Kondensatorwickel 1 und dem Gehäuseboden 5 durch Festziehen von Schrauben auf dem Gewindebolzen 3 verspannt. Der Kondensatorwickel 1 und seine Kontaktierung sind schließlich noch von einem Gehäuse 7 mit dem Gehäuseboden 5 umgeben, was für eine Hochfrequenz-Abdichtung sorgt.

Auf diese Weise wird eine lötfreie, schonende, konzentrische und hochfrequenzdichte Kontaktierung des temperaturempfindlichen Kunststoff-Kondensatorwickels 1 erreicht.

Fig. 2a zeigt als weiteres Ausführungsbeispiel des erfindungsgemäßen lötfreien koaxialen Durchführungs-Bauelements einen Schnitt durch einen koaxialen Durchführungsfilter mit in einem Kontaktnapf 8 vorgesehenen induktiven Bauteilen 9 und Kondensatorwickeln 10, die über Meshgewebe 6 in ähnlicher Weise wie bei dem Ausführungsbeispiel von Fig. 1 kontaktiert sind. Diese Meshgewebe 6 sind mit den Kondensatorwickeln 10 durch Festziehen einer Gehäusehülse 11 verspannt, die mit einem Gehäuseanschluß 12 verschraubt ist. Über die in Fig. 2a "äußeren" Meshgewebe 6 wird dabei das Gehäusepotential angelegt, während die beiden "mittleren" Meshgewebe 6 mittels des Kontaktnapfes 8 jeweils mit dem Bolzenpotential beaufschlagt sind.

Zwischen den beiden mit den "mittleren" Meshgeweben 6 verbundenen Endteilen der Kontaktnäpfe 8 kann gegebenenfalls ein Isolierteil 25 vorgesehen sein, wie dies in Fig. 2b gezeigt ist. Dieser Isolierteil 25 dient zur elektrischen Trennung. Hier ist zur Verdeutlichung der Kontaktnapf 8 in der linken Hälfte hervorgehoben dargestellt. Über diesen Kontaktnapf 8 und das Meshgewebe 6 wird das Bolzenpotential A zugeführt, während das Gehäusepotential B am in der Fig. 2b linken Ende über eine Kontaktscheibe 26 und das Meshgewebe 6 anliegt. Die Wickelpakete sind auch über die Kontaktscheibe 26 bzw. den Kontaktnapf im Gehäuse verspannt.

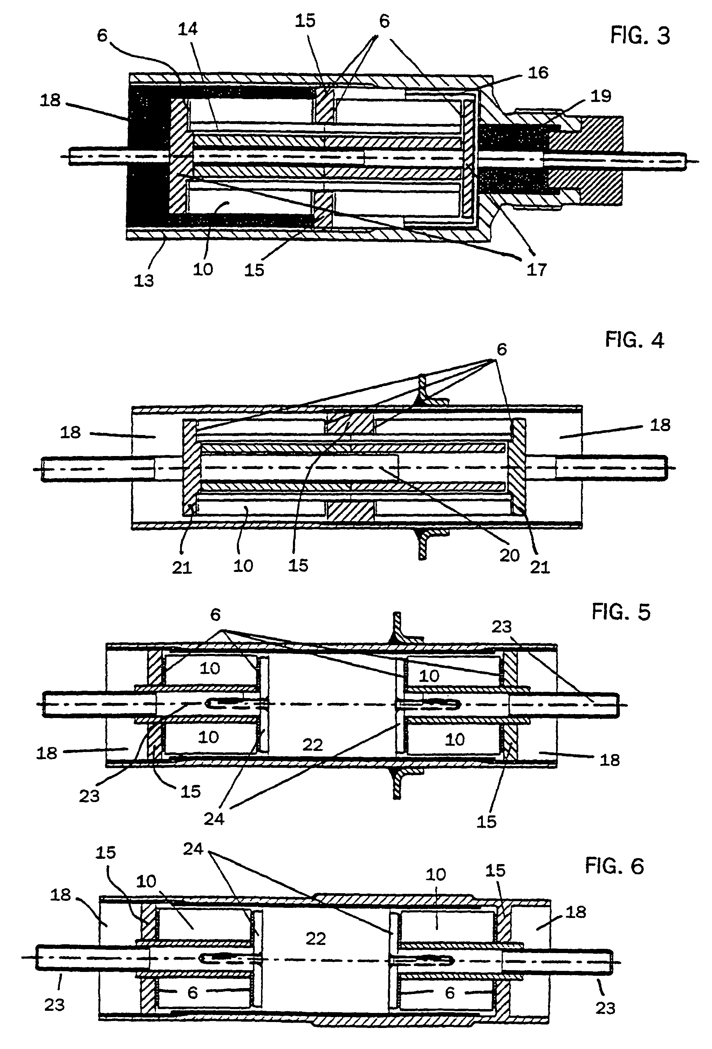

Fig. 3 zeigt einen Durchführungsfilter mit einem Sockelgehäuse 13, in das der komplette Einbau eingeschraubt ist. Dieser umfaßt insbesondere Rohr-Kerne 14, Wickel 10, verschraubte Gehäusekontaktierungen 15, eine Isolierkappe 16, Meshgewebe 6 und Bolzenkontaktierungen 17. Die Gehäusekontaktierung 15 liegt auf einem ersten Wickelpotential, während die Bolzenkontaktierung 17 auf einem zweiten Wickelpotential vorgesehen ist. Mittels einer Vergußmasse 18 und einer Kleberschicht 19 ist die gesamte Anordnung in dem Sockelgehäuse 13 feuchtigkeitsdicht untergebracht. Auch bei diesem Ausführungsbeispiel sind die Meshgewebe 6 gegen die jeweiligen Kontaktflächen der Wickel 10 gepreßt, so daß eine zuverlässige, lötfreie Kontaktierung gegeben ist.

Im Ausführungsbeispiel von Fig. 4, das ebenfalls einen komplett in ein Gehäuse geschraubten Einbau (Bolzen, Kerne, Wikkel und Kontaktscheiben) 20 mit einer Gehäusekontaktierung 15, Wickeln 10 und Vergußmassen 18 zeigt, liegen ebenfalls Meshgewebe 6 zwischen Kontaktierungs- bzw. Druckelementen oder Kontaktscheiben 21 und den Wickeln 10, so daß eine zuverlässige Kontaktierung der Wickel 10 über die Meshgewebe 6 zu den Druckelementen 21 gewährleistet ist. Gleiches gilt für die Meshgewebe 6, die zwischen den Wickeln 10 und den Gehäusekontaktierungen 15 vorgesehen sind.

Die Ausführungsbeispiele der Fig. 3 und 4 zeigen so einen verschraubten und meshkontaktierten Einbau 20 mit je einer Wickelseite auf Bolzenpotential, bei dem gleichzeitig die beiden anderen Wickelseiten auf Gehäusepotential gebracht sind. Es liegt hier eine vollkommen lötfreie Konstruktion vor, bei der die Kontaktgabe lediglich über die Meshgewebe 6 erfolgt.

Im Unterschied zu den Fig. 3 und 4 zeigen die Fig. 5 und 6 zwei weitere Ausführungsbeispiele der Erfindung, bei denen identische Anschlußelemente mit einer Drossel 22 auf Bolzenpotential verbunden sind, während die Kontaktierung von Wikkeln 10 wiederum über Meshgewebe 6 erfolgt. Anschlußelemente 23 auf Bolzenpotential sind dabei zu der Drossel 22 über Bolzenkontaktierungen 24 geführt. An den Meshgeweben 6 liegen Gehäusekontaktierungen 15.

Fig. 5 zeigt ein beidseitig verschraubtes Flanschgehäuse, während in Fig. 6 ein einseitig verschraubtes Rohrgehäuse dargestellt ist. Beide Gehäuse sind an ihren beiden Enden durch eine Vergußmasse 18 abgedichtet.

## Patentansprüche

1. Lötfreies, koaxiales Durchführungs-Bauelement mit wenigstens zwei Elektroden, die in ein Gehäuse (7) des Bauelements eingeführt sind, in welchem mindestens ein Druckelement (4, 5) mit einer Kontaktfläche des Bauelements verspannt ist,
**dadurch gekennzeichnet,**
**daß** zwischen dem Druckelement (4, 5) und der Kontaktfläche ein Metallgestrick-Kontakt-Element (6) verspannt ist.

2. Lötfreies, koaxiales Durchführungs-Bauelement nach Anspruch 1,
**dadurch gekennzeichnet,**
**daß** das Metallgestrick-Kontakt-Element aus einem verzinnten oder vernickelten Kupferdraht oder ähnlich gut leitenden Metalldrähten besteht.

3. Lötfreies, koaxiales Durchführungs-Bauelement nach Anspruch 2,
**dadurch gekennzeichnet,**
**daß** es ein koaxialer Durchführungskondensator oder ein koaxialer Durchführungsfilter ist.

4. Lötfreies, koaxiales Durchführungs-Bauelement nach einem der Ansprüche 1 bis 3,
**dadurch gekennzeichnet,**
**daß** das Gehäuse durch eine Vergußmasse (18) abgedichtet ist.

5. Lötfreies, koaxiales Durchführungs-Bauelement nach einem der Ansprüche 1 bis 4,
**dadurch gekennzeichnet,**
**daß** das Gehäuse einseitig (vgl. Fig. 6) oder beidseitig (vgl. Fig. 5) verschraubt ist.

6. Lötfreies, koaxiales Durchführungs-Bauelement nach einem der Ansprüche 1 bis 5,
**dadurch gekennzeichnet,**
**daß** das Gehäuse ein Sockelgehäuse (13) oder ein Rohrgehäuse oder ein Flanschgehäuse ist.

7. Lötfreies, koaxiales Durchführungs-Bauelement nach einem der Ansprüche 1 bis 6,
**dadurch gekennzeichnet,**
**daß** das Meshgewebe (6) mit einer Gehäusekontaktierung (15) verbunden ist.

8. Lötfreies, koaxiales Durchführungs-Bauelement nach einem der Ansprüche 1 bis 7,
**dadurch gekennzeichnet,**
**daß** das Meshgewebe mit einer Bolzenkontaktierung (24) verbunden ist.

## Claims

1. Solderless, coaxial bushing component having at least two electrodes which are inserted into a housing (7) of the component and in which at least one contact-pressure element (4, 5) is clamped to a contact surface of the component,
**characterized**
**in that** a metal mesh contact element (6) is clamped between the contact-pressure element (4, 5) and the contact surface.

2. Solderless, coaxial bushing component according to Claim 1,
**characterized**
**in that** the metal mesh contact element is composed of a galvanized or nickel-plated copper wire, or of similarly highly conductive metal wires.

3. Solderless, coaxial bushing component according to Claim 2,
**characterized**
**in that** said component is a coaxial bushing capacitor or a coaxial bushing filter.

4. Solderless, coaxial bushing component according to one of Claims 1 to 3,
**characterized**
**in that** the housing is sealed by an encapsulation compound (18).

5. Solderless, coaxial bushing component according to one of Claims 1 to 4,
**characterized**
**in that** the housing is screwed on one side (see Figure 6) or on both sides (see Figure 5).

6. Solderless, coaxial bushing component according to one of Claims 1 to 5,
**characterized**
**in that** the housing is a socket housing (13), a tubular housing or a flanged housing.

7. Solderless, coaxial bushing component according to one of Claims 1 to 6,
**characterized**
**in that** the mesh (6) is connected to a housing contact (15).

8. Solderless, coaxial bushing component according to one of Claims 1 to 7,
**characterized**
**in that** the mesh is connected to a bolt contact (24).

## Revendications

1. Composant coaxial de traversée, sans soudure, comprenant au moins deux électrodes qui sont introduites dans un boîtier (7) du composant, dans lequel au moins un élément (4, 5) de pression est bloqué par une surface de contact du composant,
**caractérisé**
**en ce qu'**un élément (6) de contact en toile métallique est bloqué entre l'élément (4, 5) de pression et la face de contact.

2. Composant coaxial de traversée, sans soudure, suivant la revendication 1,
**caractérisé**
**en ce que** l'élément de contact en toile métallique est en un fil de cuivre étamé ou nickelé ou en des fils métalliques pareillement bon conducteurs.

3. Composant coaxial de traversée, sans soudure, suivant la revendication 2,
**caractérisé**
**en ce que** c'est un condensateur coaxial de traversée ou un filtre coaxial de traversée.

4. Composant coaxial de traversée, sans soudure, suivant l'une des revendications 1 à 3,
**caractérisé**
**en ce que** le boîtier est rendu étanche par une composition (18) de scellement.

5. Composant coaxial de traversée, sans soudure, suivant l'une des revendications 1 à 4,
**caractérisé**
**en ce que** le boîtier est vissé d'un côté (voir la figure 6) ou des deux côtés ( voir la figure 5).

6. Composant coaxial de traversée, sans soudure, suivant l'une des revendications 1 à 5,
**caractérisé**
**en ce que** le boîtier est un boîtier (13) à culot ou un boîtier tubulaire ou un boîtier à brides.

7. Composant coaxial de traversée, sans soudure, suivant l'une des revendications 1 à 6,
**caractérisé**
**en ce que** la toile (6) à mailles est reliée à un dispositif (15) de mise en contact de boîtier.

8. Composant coaxial de traversée, sans soudure, suivant l'une des revendications 1 à 7,
**caractérisé**
**en ce que** la toile à mailles est reliée à un dispositif (24) de contact d'axe.
